# EUROPEAN PATENT APPLICATION

(11) **EP 4 592 430 A1**
(43) Date of publication of application: **30.07.2025**
(21) Application number: 23938062.9
(22) Date of filing: 15.06.2023
(51) Int. Cl.: C30B 29/32, C30B 11/00, G01T 1/202

(54) **CERIUM-DOPED BISMUTH GERMANATE SINGLE CRYSTAL SCINTILLATOR, PREPARATION METHOD THEREFOR, AND USE THEREOF**

(30) Priority: 24.05.2023 CN 202310590409
(71) Applicant: Shanghai Institute of Ceramics, Chinese Academy of Sciences, Shanghai 200050 (CN)
(72) Inventor: CHEN, Junfeng, Shanghai 200050 (CN); CHEN, Lei, Shanghai 200050 (CN); QI, Xuejun, Shanghai 200050 (CN); LI, Xiang, Shanghai 200050 (CN); DENG, Mingxue, Shanghai 200050 (CN); ZHAO, Peng, Shanghai 200050 (CN); WANG, Jiacheng, Shanghai 200050 (CN); WANG, Dong, Shanghai 200050 (CN)
(74) Representative: Herrmann, Daniel
(86) International application number: PCT/CN2023/100382
(87) International publication number: WO 2024/239393

(57) **Abstract**

The present invention relates to a cerium doped bismuth germanate single crystal scintillator and preparation method and application thereof. The chemical formula of the cerium doped bismuth germanate single crystal scintillator is Bi₄Ge₃O₁₂:Ce, wherein the doping amount of Ce element is not higher than 0.7 wt%.

## Description

### Technical Field

The present invention relates to a cerium doped bismuth germanate single crystal scintillator for improving a scintillation performance of bismuth germanate, preparation method and application thereof, belonging to the field of scintillators for radiation detection.

### Background

Scintillator is a class of functional material that can convert energy absorbed by high-energy particles or radiation into ultraviolet visible or near-infrared photons, which can be converted into electrical signals through photodetectors such as photomultiplier tubes and silicon photomultiplier tubes (SiPM), thereby achieving precise detection and identification of the type, quantity, energy, direction, and position of high-energy particles or radiation. Scintillation detectors based on scintillators have been widely used in fields such as high-energy physics, medical imaging, safety check, resource exploration, environmental monitoring, and industrial detection.

Doping is a reliable means to improve and enhance the shortcomings of existing scintillation materials. With the differentiated demand for radiation detection, while researching and developing novel scintillators with better performance, people have been trying to improve the scintillation performance of existing materials with a large-scale manufacturing capability through doping. For example, calcium cerium co-doping is used to shorten the decay time of lutetium silicate crystals and enhance their light output *(*M. A. Spurrier et al., Effects of Ca2+ Co-Doping on the Scanning Properties of LSO:Ce, IEEE Trans. Nucl. Sci., 55 (2008): 1178-1182*);* yttrium doping is used to suppress slow scintillation component with a light output 4-5 times that of fast scintillation component in barium fluoride scintillation crystals (J. Chen et al., Slow Scanning Suppression in Yttrium Doped BaF2 Crystals, IEEE Trans. Nucl. Sci. 65 (2018): 2147-2151*);* fluorine doping is used to improve the light output of lead tungstate scintillation crystals, and yttrium doping in lead tungstate scintillation crystals is used to improve their transmittance and light response uniformity (Wang Shaohua, Macroscopic defects and doping effects of lead tungstate crystals, doctoral thesis, Shanghai Institute of Ceramics, Chinese Academy of Sciences, 1999*).*

Bismuth germanate (Bi₄Ge₃O₁₂, BGO) crystal is an inorganic scintillator with excellent comprehensive performance, having outstanding advantages such as a high density (7.13 g/cm³), a high effective atomic number (Z_{eff}, 74), a strong radiation blocking ability, a high detection efficiency, a moderate energy resolution, a large intrinsic peak/Compton ratio, a good uniformity, no luminescence self absorption, no afterglow, a stable physical and chemical property, and a good machinability. It has been widely and significantly used in fields such as high-energy physics, astrophysics, nuclear physics, nuclear medical imaging, geological exploration, oil logging, and industrial inspection, etc. Since the 1980s, bismuth germanate crystals have achieved a large-scale production, and with the deepening of research and development, new breakthroughs in size and performance thereof have been continuously made. So far, bismuth germanate crystals are still one of the most important and widely used inorganic scintillators. The Circular Electron Positron Collider (CEPC) and Future Circular Collider (FCC) are intensity-cutting-edge large-scale scientific facilities with significantly higher beam intensity than existing Large Hadron Colliders (LHC) and other facilities. This puts higher demands on the hardness and time response characteristics of scintillation crystals.

### Technical problem

Silicon photomultiplier tube (SiPM) is a novel type of highly sensitive semiconductor photodetector device, composed of an array of Geiger mode pixels operating in parallel, each pixel consisting of an avalanche photodiode and a quenching resistor connected in series. SiPM has the characteristics of high quantum efficiency, high gain, good signal-to-noise ratio, fast time response, low operating voltage, insensitivity to magnetic fields, and compact structure. It has become a preferred scintillation light detection device for high-energy physics facilities such as CEPC and FCC, and is also a preferred light readout choice for various scintillation detectors. Due to the high number of scintillation photons generated by GeV-TeV high-energy particles, when all pixels detect photons simultaneously, the output signal of SiPM will saturate, resulting in no more pixels available to detect other incident photons, which directly affects the dynamic range and accuracy of the energy meter. Although the light output of crystals can be reduced through methods such as attenuation plates, their stability and reliability in strong radiation environments cannot be guaranteed. Therefore, it is urgent to reduce the light output of BGO crystals to better meet the urgent application needs of large-scale scientific facilities such as CEPC and FCC.

In addition, after being exposed to a certain dose of high-energy particles, radiation, or ultraviolet radiation, BGO crystals undergo a decline in the scintillation performance due to coloring, which in turn affects the light response uniformity of crystal, known as "radiation damage". How to reduce radiation damage effects has always been an important direction in the research and development of BGO crystals. Furthermore, BGO crystals have a long decay time of ~0.3 µs, which limits their application in high counting rate radiation detection such as high-energy physics and resource exploration. Therefore, how to shorten their decay time has also received continuous attention.

### Technical solution

In view of this, the purpose of the present invention is to provide a cerium doped bismuth germanate single crystal scintillator that reduces a light output of BGO scintillators, improves their radiation resistance, and shortens their decay time, as well as a preparation method and application thereof.

In the first aspect, the present invention provides a cerium doped bismuth germanate single crystal scintillator, wherein the chemical formula of the cerium doped bismuth germanate single crystal scintillator is Bi₄Ge₃O₁₂:Ce, wherein the doping amount of Ce element is not higher than 0.7 wt%. Preferably, the Ce element exists in two ion forms of Ce³⁺ and Ce⁴⁺.

In the present disclosure, after doping with cerium, cerium exists in two ion forms of Ce³⁺ and Ce⁴⁺ in the BGO scintillator. Due to the fact that the ionic radius of Ce³⁺ (r = 1.01 Å) and Ce⁴⁺ (r = 0.87 Å) are much larger than that of Ge³⁺(r = 0.53 Å), while the ionic radius of Bi³⁺ (r = 1.03 Å) is slightly larger than that of Ce³⁺ and Ce⁴⁺, therefore, according to the general principle that doped ions must have a ionic radius similar to that of substituted ions in the matrix lattice, the doped Ce ion can occupy the lattice position of Bi³⁺ ions in BGO scintillators. Moreover, the irradiation induced valence change of Ce ions can suppress the formation of color centers caused by radiation in Bi₄Ge₃O₁₂, thereby enhancing a radiation resistance of Bi₄Ge₃O₁₂. In addition, the present disclosure reduces a light output of BGO by Ce doping, which not only suppresses radiation damage but also shortens its decay time, thus having an important research significance and practical value. The emission peak of the cerium doped bismuth germanate single crystal scintillator in the present invention does not shift, avoiding the impact on detection efficiency caused by the shift of the emission peak.

Preferably, the doping amount of Ce element is 0.005 wt% to 0.5 wt%. Preferably, the doping amount is 0.01 wt% to 0.4 wt%. More preferably, the doping amount is 0.04 wt% to 0.2 wt%.

Preferably, the cerium doped bismuth germanate single crystal scintillator has a size that reaches a centimeter level in at least one dimension of length, width, and height. Preferably, the cerium doped bismuth germanate single crystal scintillator has a length of at least 1 cm, a width of at least 1 cm, and a height of at least 1 cm.

In the second aspect, the present invention provides a preparation method for the cerium doped bismuth germanate single crystal scintillator, comprising:
(1) weighing Bi₂O₃ powder, GeO₂ powder, and Ce source according to chemical composition Bi₄Ge₃O₁₂:xCe, and mixing them to obtain a mixed powder;
(2) directly loading the mixed powder into a crucible, or before loading the mixed powder into a crucible subjecting them to a melting reaction, and growing using Bridgman method, Czochralski method, Kyropoulos method, heat exchange method, or Micro-pulling-down method to obtain a cerium doped bismuth germanate single crystal scintillator.

Preferably, the purity of the Bi₂O₃ powder is greater than or equal to 99.9%;
the purity of the GeO₂ powder is greater than or equal to 99.9%;
the Ce source is selected from at least one of CeO₂, Ce₂O₃, and Ce salts.

Furthermore, preferably, the Ce salt is selected from at least one of CeF₃ and Ce(NO₃)₃.

Preferably, the melting reaction has a temperature of 900 - 1,200 °C, and a constant temperature time of 2 - 10 hours.

Preferably, the parameters of the Bridgman method include: a growth temperature of 900 - 1,300 °C, and a descending rate of 0.2 - 1 mm/h.

Preferably, the parameters of the Czochralski method include: a growth temperature of 900 - 1,300 °C, a rotational speed of 3 - 20 r/min, and a pulling speed of 0.2 - 3 mm/h.

Preferably, the parameters of the Kyropoulos method include: a growth temperature of 900 - 1,300 °C, and a growth rate of 0.1 - 3mm/h.

Preferably, the parameters of the heat exchange method include: a growth temperature of 900 - 1,300 °C, a constant temperature time of 1 - 24 hours, and a cooling rate of 1 - 10 °C/h.

Preferably, the parameters of the Micro-pulling-down method include: the growth temperature of 1,000 - 1,300 °C, and a crucible descending rate of 1 -10 mm/h.

In the third aspect, the present invention provides an application of cerium doped bismuth germanate single crystal scintillator in the radiation detection, which includes high energy physics, nuclear physics, space physics, oil logging, geological exploration, safety check, and industrial inspection. In practical applications, the cerium doped bismuth germanate single crystal scintillator can be coupled with one of SiPM, PMT, CCD or CMOS detectors to form a small detection module, and the module can be assembled into a two-dimensional or three-dimensional detection array according to the requirements of practical application. Based on this, high-energy rays or particles interact with the detection array module and are recorded.

### Beneficial Effect

The present invention can reduce a light output of BGO scintillators, improve their radiation resistance, shorten their decay time, thus significantly improve the scintillation characteristics of BGO by doping cerium elements. The cerium doped bismuth germanate (BGO:Ce) single crystal scintillator obtained in the present invention can be applied in the fields of radiation detection such as high-energy physics, nuclear physics, space physics, oil logging, geological exploration, safety check, industrial inspection.

### Brief Description of Drawings

Fig.1 shows photos of a pure BGO single crystal and BGO:Ce single crystals grown by the Bridgman method.
Fig.2 shows UV - visible optical transmittance curves of a pure BGO single crystal and BGO:Ce single crystals.
Fig.3 shows a gamma ray pulse height spectra of a pure BGO single crystal and BGO:Ce single crystals.
Fig.4 shows a normalized light output of a pure BGO single crystal and BGO:Ce single crystals as a function of irradiation time.
Fig.5 shows a gamma ray pulse time spectra of a pure BGO single crystal and BGO:Ce single crystals.
Table 1 in Fig.6 shows the preparation parameters of Bi₄Ge₃O₁₂:Ce single crystals of the present invention.
Table 2 in Fig.7 shows the performance parameters of some Bi₄Ge₃O₁₂:Ce single crystals prepared by the present invention.

### Detailed Description of Preferred Embodiments

The present invention will be further illustrated by the following embodiments below, and it should be understood that the following embodiments are only used to illustrate the present invention rather than to limit it.

In the present disclosure, the chemical formula of cerium doped bismuth germanate single crystal scintillator is Bi₄Ge₃O₁₂:Ce, wherein the doping amount of Ce element is not higher than 0.7 wt% (e.g. 0.01%, 0.05%, 0.1%, 0.2%, 0.3%, 0.4%, 0.5%, 0.6%, 0.7%, etc.). Preferably, the doping amount of Ce element is 0.005 wt% to 0.5 wt%, and more preferably, the doping amount of Ce element is 0.04 wt% to 0.2 wt%. If the doping amount of Ce element is too high, the grown Bi₄Ge₃O₁₂:Ce single crystal will produce more defects.

The following examples illustrate the preparation method of the cerium doped bismuth germanate single crystal scintillator.

Bi₂O₃ and GeO₂ are used as raw materials, and one or more mixtures of CeO₂, Ce₂O₃, CeF₃, Ce(NO₃)₃ and other Ce oxides or Ce salts are used as dopants. The weight of the above materials is determined by the doping amount of Ce element. The above materials are weighed and then mixed to obtain a mixed powder.

The mixed powder is directly loaded into a single crystal growth crucible or subjected the mixed powder to a melting reaction before loading it into a single crystal growth crucible, and grown using methods including but not limited to Bridgman method, Czochralski method, Kyropoulos method, heat exchange method, or micro-pulling down method, to obtain a cerium doped bismuth germanate single crystal scintillator.

The present invention reduces the light output of the crystal within an appropriate range by adjusting the doping amount of cerium element, improves the radiation resistance of the crystal, and improves the time response rate of the crystal.

Examples will be taken to further illustrate the present invention in detail below. It should also be understood that the following examples are only used to further illustrate the present invention rather than to limit the protection scope of the present invention. All non-essential improvements and adjustments which are made by those skilled in the art according to the above contents of the present invention shall fall within the protection scope of the present invention. The specific technological parameters of the following examples are merely one example in an appropriate range, that is, those skilled in the art can make choices within the appropriate range through the description herein, but the choices are not limited to the specific values of the following examples.

### Example 1

Bi₂O₃ and GeO₂ were used as raw materials, and CeO₂ was used as a dopant. Bi₂O₃, GeO₂ and CeO₂ were weighed according to the corresponding weight of addition amount of 0.01wt% (Bi₂O₃: 373.98 g, GeO₂: 125.97 g, CeO₂: 0.05 g, i.e. mCeO₂/(mBi₂O₃+mGeO₂+mCeO₂)=0.01wt%) and were mixed to obtain a mixed powder.

The obtained mixed powder was put into a platinum crucible for single crystal growth, and was grown using the Bridgman method for single crystal growth to obtain a cerium doped bismuth germanate single crystal scintillator. The parameters of the Bridgman method comprised: first, placing the mixed powder in a crystal growth furnace and heating at a constant temperature of 1,300 °C for 10 hours until the materials are completely melted; then, lowering the crucible with a descending rate of 0.6 mm/h, melt slowly crystallizing from bottom to top; after crystallization, cooling down to room temperature at a rate of 20 °C/h to obtain a centimeter sized cerium doped bismuth germanate single crystal scintillator.

### Example 2

The preparation process of Bi₄Ge₃O₁₂:Ce single crystal in Example 2 referred to Example 1, with the difference being that the CeO₂ addition amount is 0.02 wt%, the growth temperature is 1,200 °C, and the growth rate is 0.5 mm/h.

### Example 3

The preparation process of Bi₄Ge₃O₁₂:Ce single crystal in Example 3 referred to Example 1, with the difference being that the CeO₂ addition amount is 0.05 wt%, the growth temperature is 1,100 °C, and the growth rate is 0.4 mm/h.

### Example 4

The preparation process of Bi₄Ge₃O₁₂:Ce single crystal in Example 4 referred to Example 1, with the difference being that the CeO₂ addition amount is 0.1 wt%, the growth temperature is 1,100 °C, and the growth rate is 0.4 mm/h.

### Example 5

The preparation process of Bi₄Ge₃O₁₂:Ce single crystal in Example 5 referred to Example 1, with the difference being that the doping agent is CeF₃, the addition amount is 0.2 wt%, the growth method is the Czochralski method, the rotational speed is 10 r/min, and the pulling rate is 1.0 mm/h.

### Example 6

The preparation process of Bi₄Ge₃O₁₂:Ce single crystal in Example 6 referred to Example 5, with the difference being that the CeO₂ addition amount is 0.5 wt%, the growth method is the Kyropoulos method, the growth temperature is 1,000 °C, and the growth rate is 1 mm/h.

### Example 7

The preparation process of Bi₄Ge₃O₁₂:Ce single crystal in Example 7 referred to Example 1, with the difference being that the doping agent s Ce(NO₃)₃, the addition amount is 0.1 wt%, the growth method is the heat exchange method, the growth temperature is 1,100 °C, the constant temperature time is 20 hours, and the cooling rate is 5 °C/h.

### Example 8

The preparation process of Bi₄Ge₃O₁₂:Ce single crystal in Example 8 referred to Example 1, with the difference being that the doping agent is CeO₂, the addition amount is 0.5 wt%, and the growth rate is 0.4 mm/h.

### Example 9

The preparation process of Bi₄Ge₃O₁₂:Ce single crystal in Example 9 referred to Example 1, with the difference being that the doping agent is Ce(NO₃)₃ (50%) and CeO₂ (50%), the addition amount is 0.1 wt%, and the growth rate is 0.4 mm/h.

### Example 10

The preparation process of Bi₄Ge₃O₁₂:Ce single crystal in Example 10 referred to Example 1, with the difference being that the doping agent is Ce(NO₃)₃ (50%), CeO₂ (25%), and CeF₃ (25%), the addition amount is 0.1 wt%, the growth method is the Micro-pulling-down method, the growth temperature is 1,100 °C, and the crucible descending rate is 5 mm/h.

### Example 11

The preparation process of Bi₄Ge₃O₁₂:Ce single crystal in Example 11 referred to Example 3, with the difference being that the CeO₂ addition amount is 0.01wt% and the growth rate is 0.4 mm/h.

### Example 12

The preparation process of Bi₄Ge₃O₁₂:Ce single crystal in Example 12 referred to Example 3, with the difference being that the CeO₂ addition amount is 0.02 wt% and the growth rate is 0.4 mm/h.

### Example 13

The preparation process of Bi₄Ge₃O₁₂:Ce single crystal in Example 13 referred to Example 3, with the difference being that the CeO₂ addition amount is 0.2 wt% and the growth rate is 0.4 mm/h.

### Example 14

The preparation process of Bi₄Ge₃O₁₂:Ce single crystal in Example 14 referred to Example 3, with the difference being that the CeO₂ addition amount is 0.3 wt% and the growth rate is 0.4 mm/h.

### Example 15

The preparation process of Bi₄Ge₃O₁₂:Ce single crystal in Example 15 referred to Example 3, with the difference being that the CeO₂ addition amount is 0.4 wt% and the growth rate is 0.4 mm/h.

### Example 16

The preparation process of Bi₄Ge₃O₁₂:Ce single crystal in Example 16 referred to Example 3, with the difference being that the CeO₂ addition amount is 0.5 wt% and the growth rate is 0.4 mm/h.

### Comparative Example 1

The preparation process of Bi₄Ge₃O₁₂ single crystal in Comparative Example 1 referred to Example 1, with the difference being that the CeO₂ addition amount is 0 wt%.

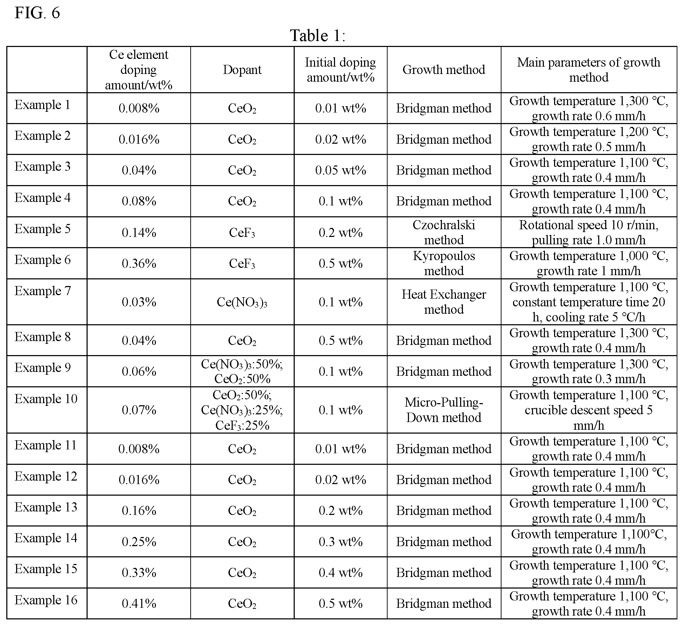

Table 1 in Fig.6 shows preparation parameters of Bi₄Ge₃O₁₂:Ce single crystals of the present invention.

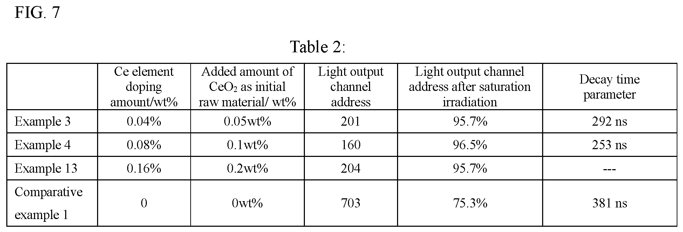

Table 2 in Fig.7 shows performance parameters of some Bi₄Ge₃O₁₂:Ce single crystals prepared by the present invention.

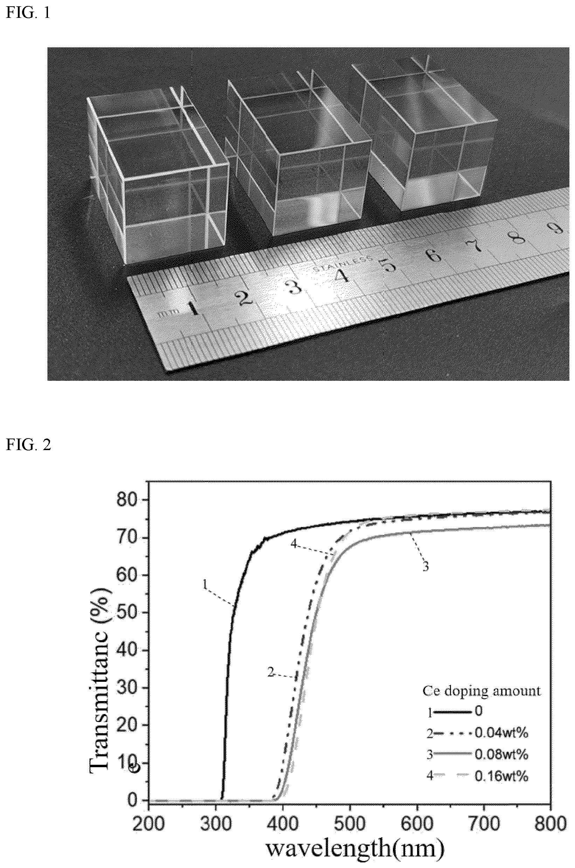

Fig.1 shows photos of pure BGO (left) and BGO:Ce (center, Ce doping amount being 0.04 wt%; right, Ce doping amount being 0.08 wt%) single crystals grown by the Bridgman method. Figure 2 shows a UV-visible optical transmittance of pure BGO and BGO:Ce single crystals. It can be seen from Figs. 1 and 2 that single crystals with high optical quality can be grown after doping with Ce element, which change from colorless transparency to light yellow, and there is a significant redshift phenomenon at the absorption edges.

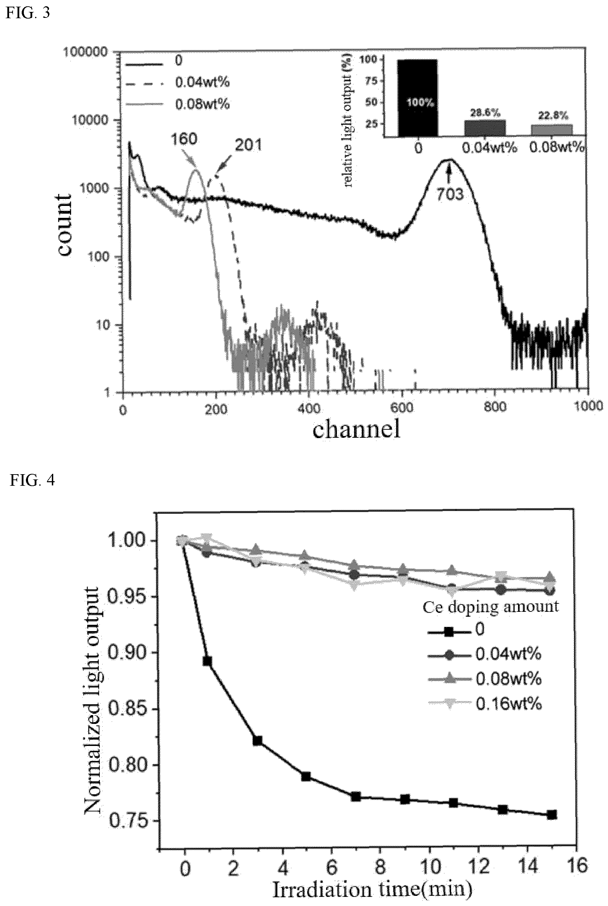

Fig.3 shows a gamma ray pulse height spectra of pure BGO and BGO:Ce single crystals. It can be seen from Fig. that after doping with Ce element, channel address that characterizes the light output of each crystal decreases from 703 of the pure crystal to 201 of Ce doped crystal (Ce element doping amount being 0.04 wt%), 160 of Ce doped crystal (Ce element doping amount being 0.08wt%), and 204 of Ce doped crystal (Ce element doping amount being 0.16 wt%).

In order to study the radiation resistance of crystals, the present invention conducted irradiation experiments on pure BGO and BGO:Ce single crystals using UVB ultraviolet light. Fig.4 shows normalized light output curves of pure BGO and BGO:Ce single crystals as a function of UV irradiation time. It can be seen from Fig.4 that the radiation resistance of the crystals is significantly increased after doping with Ce element, and the proportion of saturated irradiation light output is decreased from 25% of pure BGO crystal to 5%, while the light output of the crystal after saturation irradiation can maintain about 95% of that before irradiation. As the doping concentration of Ce element increases, the radiation resistance of the crystals first significantly enhances, then slightly decreases, but still remains above 95%. This is mainly because the doping of Ce element can significantly improve the radiation resistance of the crystals, but as the doping concentration further increases, it will lead to an increase in macroscopic defects in the crystals, making it difficult to further improve the radiation resistance. Therefore, the optimal doping amount of Ce element is 0.04 wt% to 0.2 wt%.

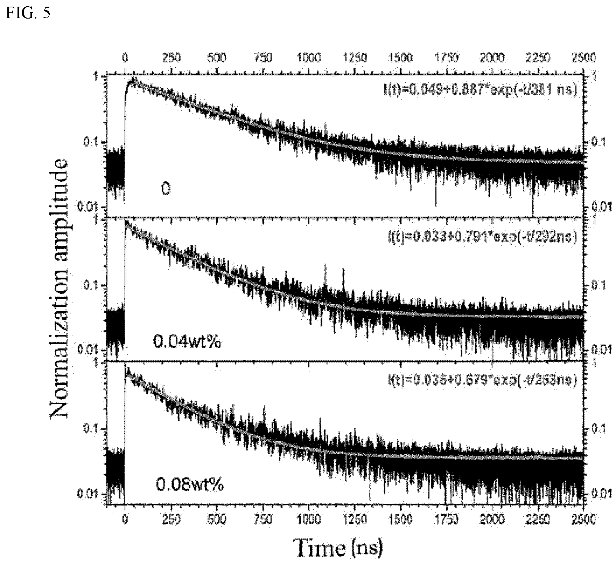

In order to determine the trend of changes in the time response characteristics of BGO crystals after irradiation, the present invention uses an oscilloscope method to obtain anode signal pulses of pure BGO and BGO:Ce single crystals under gamma ray excitation, thereby roughly obtaining a gamma ray pulse time spectra of pure BGO and BGO:Ce crystals. It can be seen From Fig.5 that the decay time of BGO crystals doped with Ce element is significantly reduced from 381 ns (pure BGO crystals) to 253 ns (Ce element doping amount being 0.08%), and the decay constant is shortened by 33.6%, significantly improving the time response characteristics of BGO crystals. This is mainly because the doping of Ce element changes the crystal field strength of activator Bi ions in the crystals, increases the probability of radiative or non radiative transitions and thus shortens the decay time, making it have better time response performance.

In the present invention, compared to pure bismuth germanate scintillators, Ce doped bismuth germanate scintillators have a lower light output, a stronger radiation resistance, and a shorter decay time, which can meet the higher requirements of high-energy physics and other applications for material light output, radiation resistance, and time response characteristics.

Finally, it is necessary to clarify that the above embodiments are only used for further detailed explanation of the technical solution of the present invention and cannot be understood as a limitation on the scope of protection of the present invention. Some non-essential improvements and adjustments made by those skilled in the art based on the above content of the present invention belong to the scope of protection of the present invention.

## Claims

1. A cerium doped bismuth germanate single crystal scintillator, wherein the cerium doped bismuth germanate single crystal scintillator has a chemical formula of Bi₄Ge₃O₁₂:Ce, wherein the doping amount of Ce element is not higher than 0.7 wt%.

2. The cerium doped bismuth germanate single crystal scintillator according to claim 1, wherein the Ce element exists in two ion forms of Ce³⁺ and Ce⁴⁺.

3. The cerium doped bismuth germanate single crystal scintillator according to claim 1, wherein the doping amount of Ce element is 0.005 wt% to 0.5 wt%.

4. The cerium doped bismuth germanate single crystal scintillator according to claim 3, wherein the doping amount of Ce element is 0.04 wt% to 0.2 wt%.

5. The cerium doped bismuth germanate single crystal scintillator according to any of claims 1 to 4, wherein the cerium doped bismuth germanate single crystal scintillator has a size that reaches a centimeter level in at least one dimension of length, width, and height.

6. A preparation method for cerium doped bismuth germanate single crystal scintillator according to any of claims 1 to 5, comprising:
(1) weighing Bi₂O₃ powder, GeO₂ powder, and Ce source according to mass percentage, and mixing them to obtain a mixed powder; and
(2) directly loading the mixed powder into a crucible, or before loading the mixed powder into a crucible subjecting it to a melting reaction, and then growing using Bridgman method, Czochralski method, temperature gradient method, heat exchange method, Kyropoulos method or micro-pulling down method to obtain a cerium doped bismuth germanate single crystal scintillator.

7. The preparation method according to claim 6, wherein the purity of the Bi₂O₃ powder is greater than or equal to 99.9%;
the purity of the GeO₂ powder is greater than or equal to 99.9%;
the Ce source is selected from at least one of CeO₂, Ce₂O₃, and Ce salts; wherein the Ce salt is selected from CeF₃ and/or Ce(NO₃)₃.

8. The preparation method according to claim 6, wherein the melting reaction has a temperature of 900 - 1,200 °C, and a constant temperature time of 2 - 10 hours.

9. The preparation method according to any of claims 6 to 8, wherein the parameters of the Bridgman method include: a growth temperature of 900 - 1,300 °C, and a descent rate of 0.2 -1 mm/h.

10. The preparation method according to any of claims 6 to 8, wherein the parameters of the Czochralski method include: a growth temperature of 900 - 1,300 °C, a rotational speed of 3 -20 r/min, and a pulling speed of 0.2 -3mm/h.

11. The preparation method according to any of claims 6 to 8, wherein the parameters of the Kyropoulos method include: a growth temperature of 900 °C - 1,300 °C, and a growth rate of 0.1 - 3mm/h.

12. The preparation method according to any of claims 6 to 8, wherein the parameters of the heat exchange method include: a growth temperature of 900 -1,300 °C, a constant temperature time of 1 - 24 hours, and a cooling rate of 1 -10 °C/h.

13. The preparation method according to any of claims 6 to 8, wherein the parameters of the micro-pulling down method include: a growth temperature of 1,000 - 1,300 °C, and a crucible descending rate of 1 -10 mm/h.

14. An application of cerium doped bismuth germanate single crystal scintillator according to any of claims 1 to 5 in radiation detection, wherein the radiation detection includes high-energy physics, nuclear, space, oil logging, geological exploration, safety inspection, and industrial detection.
